# DEMANDE DE BREVET EUROPEEN

(11) **EP 0 917 207 A1**
(43) Date de publication de la demande: **19.05.1999**
(21) Numéro de dépôt: 98402789.6
(22) Date de dépôt: 10.11.1998
(51) Int. Cl.: H01L 29/768, H01L 27/148

(54) **Dispositif semiconducteur à transfert de charges**

(30) Priorité: 14.11.1997 FR 9714312
(71) Demandeur: THOMSON-CSF, 75008 Paris (FR)
(72) Inventeur: Caranhac, Sophie, 94117 Arcueil Cédex (FR); Blanchard, Pierre, 94117 Arcueil Cédex (FR)
(74) Mandataire: Guérin, Michel

(57) **Abrégé**

L'invention concerne les dispositifs à transfert de charges constitués sous forme de registres à décalage, et plus précisément ceux qui fonctionnent selon le mode MPP (Multi-Pinned Phase), c'est-à-dire avec polarisation négative forte des électrodes pendant les phases d'attente ou d'intégration de charges photosensibles. Ces registres utilisent une barrière de potentiel créée par une implantation de compensation P dans une zone 16 située sous une première électrode de chaque étage du registre. Cette barrière sépare les étages les uns des autres.

Pour augmenter la capacité de stockage de charges pendant la phase d'intégration et la capacité de transfert de charges pendant le transfert, on prévoit que l'implantation de compensation de la zone 16 s'étend sous une partie seulement (et non sous la totalité) de la première électrode de chaque étage du registre.

Application aux capteurs d'image photosensibles, aux lignes à retard analogiques, aux mémoires analogiques à transfert de charges, fonctionnant en mode MPP pendant les phases d'attente pour limiter les pertes d'informations dues au courant d'obscurité.

## Description

L'invention concerne les dispositifs à transfert de charges, ou dispositifs CCD, et plus particulièrement ceux qui sont constitués sous forme de registres à décalage et qui fonctionnent selon deux modes qui sont respectivement un mode d'attente et un mode de transfert de charges.

On peut donner plusieurs exemples de tels dispositifs, et notamment les capteurs d'image, les lignes à retard analogiques constituées en registres à décalage, des mémoires analogiques à transfert de charges.

Dans la suite on expliquera l'invention surtout à propos des capteurs d'image, dont le fonctionnement se déroule sur deux périodes : une période d'attente qui est une période d'intégration de charges générées par la lumière, dans un registre à transfert de charges de plusieurs étages, et une période de transfert de ces charges d'un étage à l'autre le long du registre.

Un tel dispositif photosensible à transfert de charges comprend classiquement :
- un substrat semi-conducteur de type P à la surface duquel on a implanté une couche de type N dite "couche de transfert en volume", dans laquelle sont recueillies les charges engendrées par la lumière pendant la période d'intégration, et dans laquelle sont ensuite transférées ces charges pendant la période de transfert; la couche de transfert en volume est en général recouverte d'une fine couche isolante;
- et des électrodes placées au dessus de la couche isolante, ces électrodes permettant de créer des puits de potentiel dans la couche N, en fonction du potentiel qui leur est appliqué; ces électrodes sont juxtaposées de telle manière que les combinaisons successives de potentiel appliqués aux électrodes permettent d'une part le stockage de charges électriques sous certaines électrodes et d'autre part le transfert de ces charges d'une électrode à la suivante ou d'un groupe d'électrodes au suivant.

Dans un mode de fonctionnement particulier, connu sous l'appellation anglaise "Multi-Pinned-Phase" ou mode MPP, on prévoit que toutes les électrodes sont portées à un potentiel fortement négatif pendant la phase d'intégration de charger. Il s'établit alors en surface de la couche de transfert en volume une couche d'accumulation de porteurs mobiles positifs. Cette couche d'accumulation est en fait reliée au substrat P par diverses zones implantées profondes de type P présentes dans le substrat. Elle est donc portée au potentiel du substrat et elle maintient la surface du semiconducteur à un potentiel de référence qui est celui du substrat. Ceci a pour effet de réduire le courant d'obscurité du dispositif en neutralisant les porteurs de charge générés à l'interface entre le semiconducteur et la couche isolante.

Le potentiel de surface du semiconducteur tend alors à être le même au dessous de toutes les électrodes portées à ce potentiel négatif; il y a un problème d'absence de confinement des charges entre les étages du registre pendant la période d'intégration : les charges générées par la lumière dans un étage du registre ne sont pas naturellement confinées au dessous de cet étage pendant la période d'intégration. Ceci est bien sûr incompatible avec le principe de l'élaboration d'une image, qui demande au contraire que les charges engendrées dans un étage restent bien confinées dans cet étage. C'est pourquoi on prévoit d'empêcher la communication entre deux étages adjacents en établissant une barrière de potentiel, constituée par une implantation de type P dans la couche de transfert en volume sous une des électrodes d'un étage du registre. Cette implantation relève localement le potentiel dans la couche de transfert en volume, ce qui constitue une barrière empêchant le passage des charges d'un étage à l'autre du registre pendant la période d'intégration.

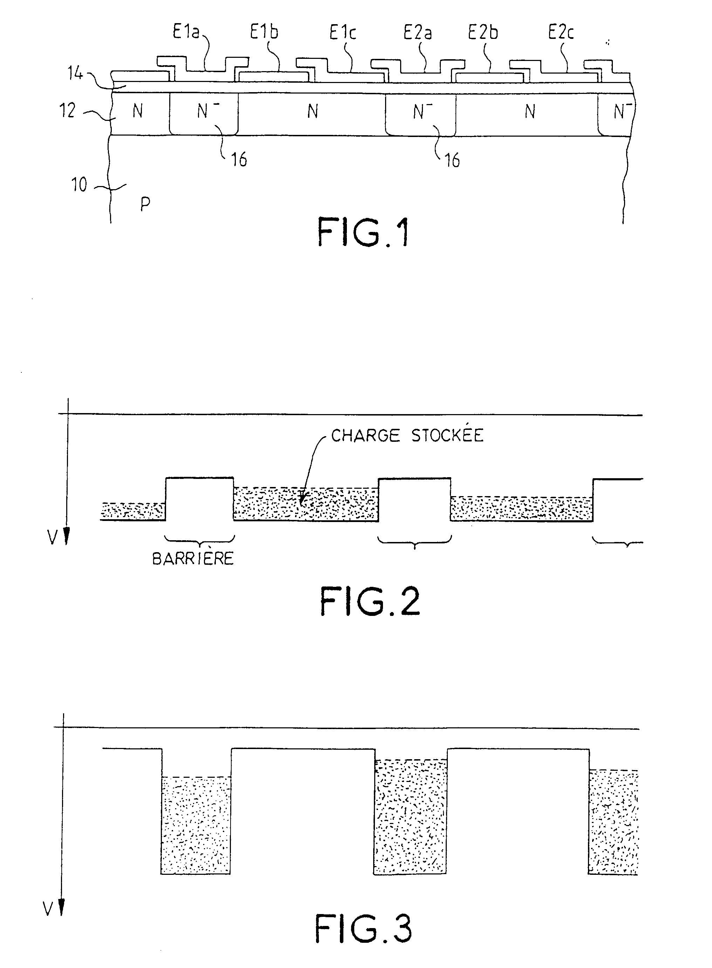

La figure 1 représente une coupe schématique d'un dispositif à transfert de charges de ce type. Il comporte un substrat semiconducteur 10 de type P, une couche 12 de transfert en volume, de type N, à la partie supérieure du substrat, une fine couche isolante 14 sur la couche 12, et des électrodes au dessus de la couche isolante

Le registre photosensible comprend plusieurs étages et chaque étage comprend plusieurs électrodes. Le registre représenté est un registre à trois phases dans lequel chaque étage comprend trois électrodes : E1a, E1b, E1c pour un étage, E2a, E2b, E2c pour l'étage suivant, etc.

Sous la première électrode de chaque étage, c'est-à-aire sous les électrodes E1a, E2a, etc., on a implanté une impureté de compensation de type P (bore par exemple), qui modifie localement le dopage de la couche de transfert en volume. La compensation est en principe insuffisante pour que le type de conductivité soit inversé. Les zones 16 sous les électrodes E1a, E2a sont donc toujours des zones de type de conductivité N, mais leur dopage équivalent de type N est plus faible que celui du reste de la couche de transfert en volume 12. On a symbolisé par l'appellation N⁻ cette conductivité N plus faible dans les zones 16.

Les potentiels appliqués aux trois électrodes en mode MPP sont identiques pendant la période d'intégration (environ -8 volts classiquement). Du fait de la conductivité réduite N⁻ dans les zones 16, la profondeur du puits de potentiel créé sous la première électrode est plus faible que la profondeur du puits créé sous les deuxième et troisième électrodes de chaque étage pendant la période d'intégration. Il en résulte une barrière de potentiel qui empêche le passage de charges d'un étage à l'autre du registre pendant cette période. Les charges générées par la lumière restent confinées sous la deuxième et la troisième électrodes.

La figure 2 représente les potentiels dans la couche de transfert en volume pendant cette période. La charge maximale qu'on peut stocker est limitée d'une part par la surface des deuxième et troisième électrodes et d'autre part par la hauteur (relativement faible puisqu'elle ne provient que de la différence de dopage des zones 16 par rapport au reste de la couche de transfert en volume) de la barrière de potentiel ainsi créée.

Pendant la période de transfert de charges d'un étage à l'autre du registre, les électrodes ne sont plus portées à des potentiels fortement négatifs. Elles sont portées à des potentiels positifs ou nuls, en trois phases successives, pour regrouper les charges sous une seule électrode à la fois et les transférer d'une électrode à la suivante puis d'un étage au suivant.

Pendant cette phase, on s'aperçoit que la profondeur réduite du puits de potentiel créé dans la zone implantée 16 limite la quantité de charges qui peuvent être transférées par le registre. En effet, lors d'une des phases de transfert, toutes les charges se trouvent stockées sous la première électrode de chaque registre; mais le puits de potentiel créé sous cette électrode (par un potentiel positif appliqué à cette électrode) est d'autant moins profond que la hauteur de la barrière de potentiel due à l'implantation P est plus élevée.

La figure 3 représente la configuration des puits de potentiel pendant une telle phase de l'opération de transfert.

Si le registre était un registre à quatre phases (quatre électrodes par étage), les charges seraient regroupées sous deux électrodes adjacentes à la fois pendant les phases de transfert, mais le principe général de fonctionnement est le même.

Pour les registres à trois phases la limitation de capacité de stockage pendant la phase de transfert est la plus critique. Pour un registre à quatre phases, la limitation pendant la phase d'intégration est la plus critique.

D'une manière générale, on est donc confronté à la nécessité d'un compromis entre une implantation de compensation suffisamment forte pour augmenter la quantité de charges stockées pendant la période d'intégration ou période d'attente et suffisamment faible pour ne pas réduire les possibilités de stockage de charges sous la première électrode pendant la période de transfert.

Les mêmes problèmes se posent pour des structures qui ne sont pas photosensibles. C'est le cas par exemple pour une ligne à retard analogique, dans laquelle les informations, établies sous forme de paquets de charges, sont conservées dans la ligne en mode d'attente de type MPP pour réduire le courant d'obscurité, et sont transférées ensuite le long du registre. C'est le cas également pour une mémoire analogique linéaire ou matricielle dans laquelle les informations sont stockées sous forme de paquets de charge et sont conservées en attente en mode MPP avant leur utilisation. Pour ces dispositifs, il faut aussi trouver un compromis entre les capacités de stockage des cases du registre en mode d'attente et en mode de transfert.

La présente invention propose une solution pour améliorer les conditions de ce compromis.

Selon l'invention, on propose que l'implantation de compensation de type P soit faite sous une partie seulement de la première électrode de chaque étage du registre, c'est-à-dire que cette première électrode recouvre à la fois une zone de type N non compensée de la couche de transfert en volume, et une zone compensée par une impureté de type P. Sous les autres électrodes, il n'y a pas une telle implantation de compensation localisée.

Dans la technique antérieure, l'implantation de compensation de type P était réalisée dans toute la zone découverte entre la troisième dernière d'un étage et la deuxième électrode de l'étage suivant, par implantation autoalignée par rapport à ces électrodes, avant le dépôt de la couche constituant la première électrode. Ici, on utilisera un masque d'implantation supplémentaire, conservant l'autoalignement de la zone compensée d'un côté avec la troisième électrode, mais masquant une partie de la couche N du côté de la deuxième électrode.

L'invention est applicable à des registres à trois électrodes ou plus par étage notamment les (registres à trois ou quatre phases).

En d'autres mots, on propose un dispositif à transfert de charges comprenant un registre à décalage à plusieurs étages comprenant M électrodes de registre par étage, une couche de transfert en volume au dessous des électrodes, et une zone de séparation, dopée avec une impureté de compensation de type de conductivité opposé à celui de la couche de transfert, s'étendant au dessous d'une première électrode de chaque étage pour assurer la séparation des charges détectées dans les différents étages, cette implantation de compensation ne s'étendant pas au dessous des autres électrodes de l'étage, caractérisé en ce que la zone de séparation s'étend au dessous d'une partie seulement de la première électrode de chaque étage, une zone de couche de transfert en volume non compensée s'étendant au dessous d'une autre partie de cette première électrode.

La zone compensée est de préférence aussi étroite que possible compte tenu des largeurs minimales imposées dans la technologie employée.

Pour une application à un capteur photosensible, le registre lui-même peut être photosensible, les charges accumulées pendant la période d'attente pouvant être générées par la lumière dans le registre lui-même. Le registre peut également ne pas être photosensible et recevoir des charges d'un dispositif photosensible annexe. La période d'attente est alors la période pendant laquelle le registre stocke les charges en mode MPP sans les transférer. Pour les applications non photosensibles (ligne à retard, mémoire, etc.), la période d'attente est également cette pour laquelle le registre stocke les charges en mode MPP avant de les transférer en mode non MPP.

D'autres caractéristiques et avantages de l'invention apparaîtront à la lecture de la description détaillée qui suit et qui est faite en référence aux dessins annexés dans lesquels :
- les figures 1 à 3, déjà décrites, représentent la constitution et le fonctionnement d'un registre à décalage de l'art antérieur;
- la figure 4 représente schématiquement un registre à trois phases selon l'invention;
- la figure 5 représente les puits de potentiels constitués pendant la phase d'intégration de charges;
- la figure 6 représente les puits de potentiels constitués pendant l'une des phases de l'opération de transfert de charges d'un étage à l'autre.

L'invention sera décrite plus en détail à propos d'un capteur photosensible.

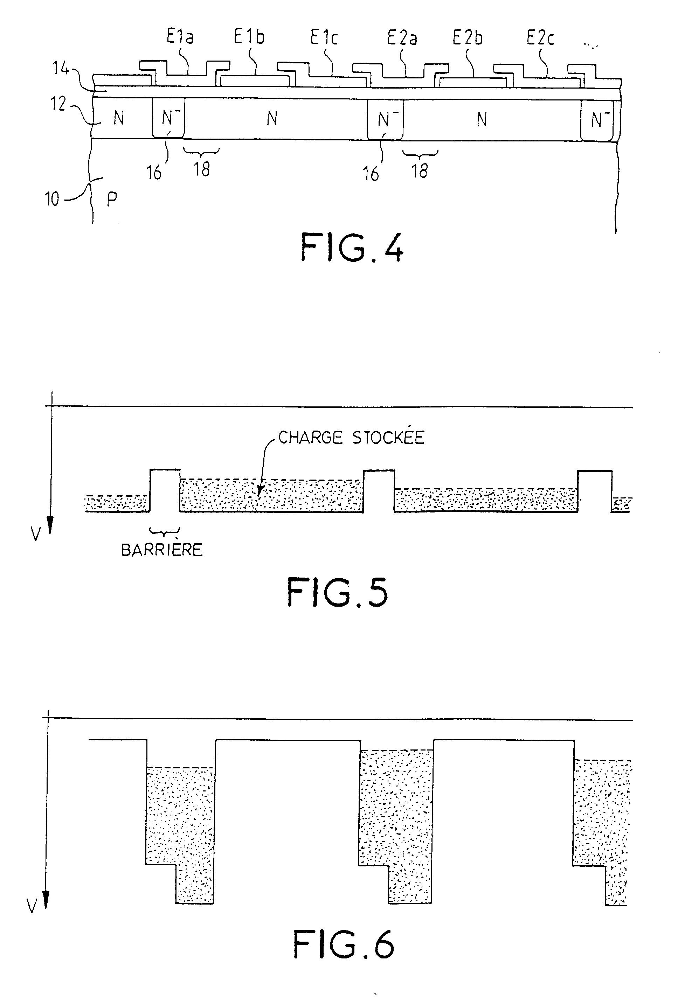

Sur la figure 4, les mêmes références qu'à la figure 1 ont été adoptées pour les mêmes éléments du registre car le registre de la figure 4 est pratiquement identique au registre de la figure 1 à l'exception de la largeur de la zone compensée 16. Celle-ci s'étend maintenant sur une partie seulement de l'espace séparant les deux électrodes qui entourent la première électrode, au lieu de s'étendre sur toute la largeur de cet espace.

Ainsi, la première électrode E2a du deuxième étage du registre est comprise entre la dernière électrode E1c de l'étage précédent et la deuxième électrode E2b du deuxième étage. La zone de couche de transfert en volume située entre ces deux électrodes E1c et E2b comprend à gauche la zone 16 dans laquelle une implantation de compensation de type P a été effectuée, et à droite une zone 18 de couche de transfert en volume non compensée.

La zone compensée est de préférence immédiatement adjacente à la zone recouverte par la dernière électrode (E1c) de l'étage précédent. Si la zone compensée était de l'autre côté (adjacente à la deuxième électrode E2b), les charges tendraient à être transférées vers la gauche sur la figure dans la période de transfert de charges. Si la zone compensée était située au milieu de l'espace surplombé par la première électrode, le transfert de charges se ferait mal.

Pour réaliser la structure de la figure 1, on formait par dépôt et gravure d'abord les deuxième et troisième électrodes des différents étages; puis on implantait l'impureté de compensation dans la zone réservée à la première électrode, sans masque d'implantation autre que les deuxième et troisième électrodes déjà déposées; la zone 16 était donc autoalignée par rapport aux électrodes; et enfin on déposait et on gravait les premières électrodes. Pour réaliser la structure de la figure 4, on procède dans le même ordre, mais l'opération d'implantation est effectuée à travers un masque qui cache la partie droite de l'espace réservé à la première électrode (c'est-à-dire qu'on masque la zone 18 située du côté de la deuxième électrode). Le masque est un masque de résine photosensible.

La largeur de la zone compensée est de préférence sensiblement égale à la largeur minimale d'implantation acceptable compte tenu de la technologie employée. Autrement dit, si la technologie utilisée possède des règles de dessin avec des largeurs d'ouverture de masque et des tolérances de positionnement de l'ordre de 1 micromètre, on prévoira une zone 16 large de 1 micromètre environ.

La figure 5 représente les puits de potentiel qui en résultent pendant la période d'intégration de charges en mode MPP (toutes les électrodes à un même potentiel négatif). Pour les mêmes surfaces d'électrodes E1a, E1b, E1c d'un étage la quantité de charges intégrées pour un éclairement donné est la même, mais la quantité de charges qu'on peut stocker entre deux barrières de potentiel est plus grande : la hauteur de la barrière de potentiel est la même (pour une même implantation de compensation) mais la surface de stockage disponible est plus grande puisqu'elle comporte maintenant une partie de la zone sous la première électrode E1a ou E2a. Les potentiels appliqués aux électrodes sont supposés être les mêmes qu'à la figure 2, par exemple -8 volts.

La figure 6 représente les puits de potentiel pendant la phase de transfert de charges durant laquelle les charges se trouvent stockées sous la première électrode de chaque étage. Pour les mêmes largeurs de première électrode qu'à la figure 1 et pour les mêmes potentiels qu'à la figure 3, la contenance du puits de potentiel est plus grande à la figure 6 qu'à la figure 3 du fait que ce n'est que la partie gauche du puits qui a une profondeur limitée par l'implantation de compensation.

On obtient donc à la fois une plus grande capacité de stockage pendant la période d'intégration et une plus grande capacité de transfert pendant la période de transfert. Les risques de saturation sont donc moins grands.

La structure de la figure 4 est une structure de registre à trois phases de transfert, donc à trois électrodes par étage. L'invention est applicable à un registre à 4 phases donc à quatre électrodes par étage, ou plus encore. Dans ce cas, c'est encore une partie de la zone sous la première électrode qui reçoit un dopage de compensation, le reste de cette zone conservant le dopage normal de la couche de transfert en volume.

## Revendications

1. Dispositif à transfert de charges comprenant un registre à décalage photosensible à plusieurs étages comprenant M électrodes de registre par étage (E1a, E1b, E1c; E2a, E2b, E2c), une couche de transfert en volume (12) au dessous des électrodes, avec une zone de séparation (16), dopée avec une impureté de compensation de type de conductivité opposé à celui de la couche de transfert, s'étendant au dessous d'une première électrode de chaque étage pour assurer la séparation des charges détectées dans les différents étages, cette implantation de compensation ne s'étendant pas au dessous des autres électrodes de l'étage, caractérisé en ce que la zone de séparation (16) s'étend au dessous d'une partie seulement de la première électrode de chaque étage, une zone de couche de transfert en volume non compensée s'étendant au dessous d'une autre partie de cette première électrode.

2. Dispositif à transfert de charges selon la revendication 1, caractérisé en ce que la zone compensée est adjacente à une zone recouverte par la dernière électrode de l'étage précédent.

3. Dispositif selon l'une des revendications 1 et 2, caractérisé en ce que la largeur de la zone compensée est sensiblement égale à la largeur minimale d'implantation possible compte tenu de la technologie employée.

4. Dispositif selon l'une des revendications précédentes, caractérisé en ce qu'il est appliqué à un capteur photosensible.

5. Dispositif selon la revendication 4, caractérisé en ce que le registre est photosensible.

6. Dispositif selon l'une des revendications 1 à 3, caractérisé en ce qu'il est appliqué à une ligne à retard.

7. Dispositif selon l'une des revendications 1 à 3, caractérisé en ce qu'il est appliqué à une mémoire analogique.
